(19) Europäisches Patentamt
European Patent Office
Office européen des brevets

(11) **EP 1 882 905 A1**

(12) **DEMANDE DE BREVET EUROPEEN**

(43) Date de publication:
**30.01.2008 Bulletin 2008/05**

(51) Int Cl.:
***G01D 5/14*** *(2006.01)* ***G01D 5/244*** *(2006.01)*

(21) Numéro de dépôt: **07290860.1**

(22) Date de dépôt: **09.07.2007**

(84) Etats contractants désignés:
**AT BE BG CH CY CZ DE DK EE ES FI FR GB GR HU IE IS IT LI LT LU LV MC MT NL PL PT RO SE SI SK TR**
Etats d'extension désignés:
**AL BA HR MK YU**

(30) Priorité: **27.07.2006 FR 0606908**

(71) Demandeur: **SNR ROULEMENTS S.A.**
**74000 Annecy (FR)**

(72) Inventeurs:
• **Desbiolles, Pascal**
**72570 Thorens Glieres (FR)**
• **Duret, Christophe**
**74600 Quintal (FR)**

(74) Mandataire: **Sayettat, Julien Christian**
**Strato-IP**
**BL 57 - 14, rue Solleillet**
**75020 Paris (FR)**

(54) **Capteur comprenant des zones sensibles délivrant des signaux d'amplitude différenciée**

(57) L'invention concerne un capteur d'un signal pseudo sinusoïdal, ledit capteur comprenant une pluralité de zones sensibles (1) qui sont aptes à délivrer chacune un signal $S_i$ représentatif du signal à détecter, les zones sensibles (1) sont agencées de sorte que, pour un même signal détecté, au moins une zone sensible (1) délivre un signal Si d'amplitude différente de celle du signal délivré par une autre zone sensible (1). L'invention concerne également des paliers équipés d'un tel capteur.

Fig. 2b

**EP 1 882 905 A1**

## Description

L'invention concerne un capteur d'un signal pseudo sinusoïdal, ainsi que des paliers équipés d'un tel capteur.

L'invention s'applique en particulier au domaine de la détermination d'une donnée angulaire, telle que la position ou la vitesse, de l'organe tournant du palier par rapport à l'organe fixe dudit palier.

Pour ce faire, on connaît du document FR-A1-2 792 403, l'utilisation d'un codeur apte à émettre un signal magnétique pseudo sinusoïdal et un capteur comprenant une pluralité de zones sensibles qui sont linéairement équiréparties, lesdites zones sensibles étant aptes à délivrer chacune un signal $S_i$ représentatif du signal émis par le codeur. Ce document prévoit en outre de combiner les signaux $S_i$ pour former deux signaux en quadrature et de même amplitude qui sont représentatifs de la position angulaire de l'organe tournant par rapport à l'organe fixe.

L'invention s'applique également à la mesure de déformations comme par exemple décrit dans le document FR-A1-2 869 980 dans lequel des signaux pseudo sinusoïdaux en quadrature et de même amplitude sont formés par combinaison de signaux délivrés par des zones sensibles.

Dans ces deux types d'application, l'art antérieur prévoit d'appliquer des gains variables aux signaux issus des zones sensibles de sorte à permettre la délivrance de signaux de même amplitude. En outre, ces réalisations peuvent permettre d'améliorer la qualité des signaux délivrés notamment en réalisant un filtrage spatial ainsi qu'en diminuant la sensibilité relativement aux défauts de positionnement du capteur ou aux défauts de réalisation du codeur.

Cette amplification, par exemple réalisée au moyen d'amplificateur électronique, présente notamment les inconvénients suivants :

-    le bruit est également amplifié, de sorte que le rapport signal sur bruit n'est pas amélioré ;
-    le bruit propre à l'amplificateur va être ajouté au signal ;
-    les plages de gain accessibles sont limitées par la tension d'alimentation des amplificateurs.

En outre, lorsque l'amplification est réalisée sur un signal qui doit être combiné à un signal non amplifié, le rapport signal sur bruit ne sera pas le même pour ces deux signaux, ce qui peut limiter les performances des dispositifs associés.

L'invention a pour but de pallier ces inconvénients en proposant notamment un capteur dont les zones sensibles sont agencées pour pouvoir s'affranchir de l'amplification électronique des signaux délivrés.

A cet effet, et selon un premier aspect, l'invention propose un capteur d'un signal pseudo sinusoïdal, ledit capteur comprenant une pluralité de zones sensibles qui sont aptes à délivrer chacune un signal $S_i$ représentatif du signal à détecter, les zones sensibles étant agencées de sorte que, pour un même signal détecté, au moins une zone sensible délivre un signal $S_i$ d'amplitude différente de celle du signal délivré par une autre zone sensible.

Selon un deuxième aspect, l'invention propose un palier équipé d'un tel capteur, ledit palier comprenant un organe fixe et un organe tournant, dans lequel un codeur délivrant un signal pseudo sinusoïdal de position est solidarisé à l'organe tournant et le capteur est solidarisé à l'organe fixe de sorte que les zones sensibles soient disposées à distance de lecture du signal émis par le codeur.

Selon un troisième aspect, l'invention propose un palier à roulement équipé d'un tel capteur, ledit palier comprenant un organe fixe et un organe tournant entre lesquels des corps roulants sont disposés pour permettre leur rotation relative en induisant un signal pseudo sinusoïdal de déformation, dans lequel les zones sensibles sont solidarisées à un organe de sorte à détecter ledit signal pseudo sinusoïdal.

D'autres particularités et avantages de l'invention apparaîtront dans la description qui suit faite en référence aux figures jointes dans lesquelles :

-    les figures 1 représentent trois variantes d'un premier mode de réalisation dans la disposition des éléments sensibles d'un capteur de sorte à former des zones sensibles délivrant respectivement un signal d'amplitude déterminée ;
-    les figures 2 représentent deux variantes d'un deuxième mode de réalisation d'un capteur agencé pour pouvoir délivrer deux signaux en quadrature et de même amplitude.

L'invention concerne un capteur d'un signal pseudo sinusoïdal, c'est-à-dire de tout signal qui est sinusoïdal par nature ou dont au moins une portion peut être approximée correctement par une sinusoïde.

Pour ce faire, le capteur comprend une pluralité de zones sensibles 1 qui sont aptes à délivrer chacune un signal $S_i$ qui est représentatif du signal à détecter.

Selon deux applications spécifiques, le signal pseudo sinusoïdal est un signal de position angulaire d'un organe tournant par rapport à un organe fixe, ou un signal de déformation périodique d'un élément structurel.

Dans la première application, notamment prévue dans le document FR-A1-2 792 403, le signal peut être émis par un codeur magnétique multipolaire. En effet, en solidarisant ce type de codeur à l'organe tournant, le signal émis est de nature pseudo sinusoïdal et fonction de la position angulaire dudit codeur par rapport au capteur. Pour détecter le signal pseudo sinusoïdal magnétique, les zones sensibles 1 peuvent comprendre notamment des sondes à effet Hall ou des magnétorésistances.

Dans la deuxième application, notamment prévue par le document FR-A1-2 869 980, le signal est induit par les déformations périodiques de l'élément structurel et les zones sensibles 1 sont des jauges de contrainte disposées sur ledit élément. En particulier, les jauges de contrainte peuvent être de nature résistive, à ondes acoustiques de surface ou de nature magnétique.

Toutefois, l'invention n'est pas limitée à ces deux applications spécifiques, et peut s'appliquer à d'autre type de signal pseudo sinusoïdal, par exemple qu'il soit de nature mécanique, optique, thermique ou acoustique, la nature des zones sensibles 1 étant alors choisie en conséquence pour pouvoir détecter le signal utilisé.

Selon l'invention, les zones sensibles 1 sont agencées de sorte que, pour un même signal détecté, au moins une zone sensible 1 délivre un signal $S_i$ d'amplitude différente de celle du signal délivré par une autre zone sensible 1. Ainsi, en ajustant l'amplitude respective des signaux $S_i$ par agencement particulier des zones sensibles 1, il est possible de s'affranchir de l'amplification ultérieure desdits signaux en fonction de l'utilisation visée pour ceux-ci.

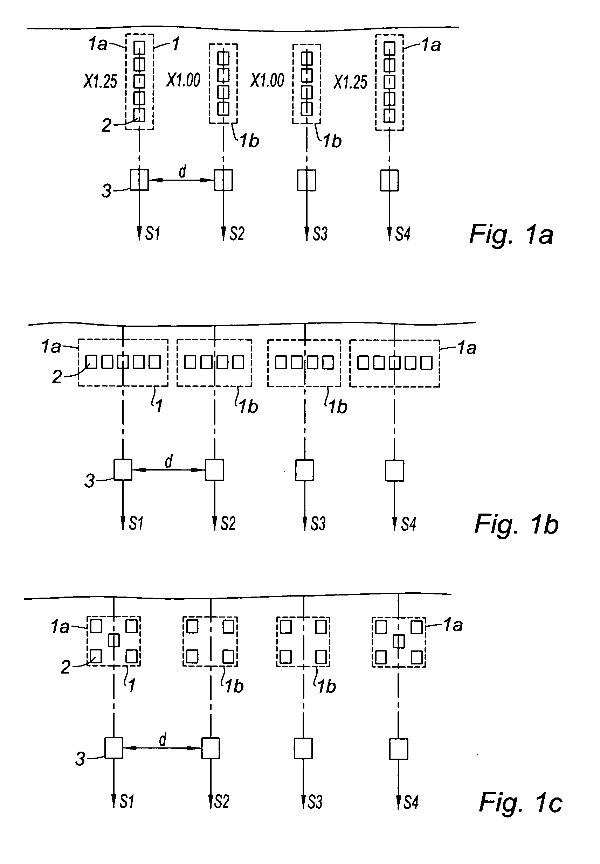

Selon le mode de réalisation représenté sur les figures 1, les zones sensibles 1 sont linéairement équiréparties. Les zones sensibles 1 comprennent une pluralité d'éléments sensibles 2 dont le nombre est ajusté pour délivrer un signal $S_i$ d'amplitude déterminée.

Pour ce faire, le signal $S_i$ de la zone sensible 1 est obtenu par sommation des signaux issus de chaque élément sensible 2 d'une zone, grâce à des moyens de sommation prévu à cet effet dans le capteur.

Sur les figures 1, quatre zones sensibles 1 sont représentées, les deux zones sensibles latérales 1a délivrant chacune un signal $S_1$ et $S_4$ d'amplitude 1,25 par rapport à l'amplitude des signaux $S_2$, $S_3$ délivrés par les zone sensibles internes 1b. Pour ce faire, les zones latérales 1a comprennent cinq éléments sensibles 2 et les zones internes 1b comprennent quatre éléments sensibles 2, lesdits éléments sensibles étant identiques pour toutes les zones 1.

Par ailleurs, les zones sensibles 1 sont schématisées par un élément 3 de taille plus importante qui est positionné au barycentre de la zone 1, les éléments étant alignés et équirépartis d'une distance d déterminée en fonction du signal pseudo sinusoïdal à détecter. Ainsi, les éléments 3 correspondent aux points de mesure virtuels équivalents avec les gains souhaités.

En prévoyant que le capteur comprenne des moyens de combinaison linéaire des signaux $S_i$, il est possible de façon connue de former deux signaux pseudo sinusoïdaux qui sont en quadrature et de même amplitude, et ce sans utilisation d'une amplification. Ainsi, il est possible d'utiliser lesdits signaux notamment pour la détermination de la position angulaire avec un interpolateur, ou de déterminer l'amplitude du signal pseudo sinusoïdal.

En variante, il est également possible de combiner les signaux $S_i$ de sorte à former un signal pseudo sinusoïdal qui corresponde à un filtrage spatial du signal émis par le codeur.

Selon la première variante de la figure 1a, les éléments sensibles 2 sont disposés perpendiculairement à la direction d'alignement des zones sensibles 1, de façon linéairement équirépartie selon cette direction. Naturellement, la longueur de l'empilement d'éléments sensibles 2 sur une zone 1 est agencée pour que chaque élément sensible 2 détecte un signal d'amplitude sensiblement identique.

Selon la deuxième variante de la figure 1b, les éléments sensibles 2 sont disposés selon la direction d'alignement des zones sensibles 1, de façon linéairement équirépartie selon cette direction.

Selon la troisième variante de la figure 1c, la zone sensible 1 présente une géométrie sensiblement carrée, les quatre éléments 2 étant disposés au voisinage des coins et le cinquième élément sensible 2 des zones latérales 1a étant disposé au centre dudit carré.

D'autre répartition des éléments sensibles 2 sur les zones 1 sont envisageables, notamment en fonction du gain souhaité et des caractéristiques du signal pseudo sinusoïdal. En particulier, si le signal est uniforme en amplitude selon l'axe vertical ou horizontal, on privilégiera respectivement l'arrangement selon la première et la deuxième variante. Si le signal est uniforme en amplitude selon les deux directions, les trois variantes peuvent convenir.

L'avantage de l'utilisation d'un nombre plus important d'éléments sensibles 2 sur une zone 1 est la réduction du bruit de mesure par un facteur $(N)^{-1/2}$ où N est le nombre d'éléments sensibles 2. En outre, l'invention permet d'améliorer le rapport signal sur bruit ainsi que la plage de gains utilisables.

Selon un autre mode de réalisation non représenté, au moins une zone sensible 1 comprend au moins un élément sensible 2 qui est agencé pour délivrer un signal $S_i$ d'amplitude déterminée. En particulier, il est possible d'ajuster l'amplitude du signal $S_i$ d'une zone sensible 1 en faisant varier un paramètre de l'élément sensible 2. Dans des exemples particuliers, le paramètre utilisé est choisi dans le groupe comprenant la géométrie de l'élément sensible 2, sa polarisation, le matériau le composant, une combinaison de ces paramètres.

Par exemple, pour une sonde à effet Hall, l'amplitude du signal de sortie peut être augmentée par :

- utilisation d'un autre matériau avec une constante de Hall plus grande ;
- augmentation du courant de polarisation de la sonde ;
- diminution de sa largeur.

Dans le cas d'une jauge de contrainte de type couche épaisse (piézorésistance), la réponse en tension peut être augmentée par :

- augmentation du courant de polarisation de la jauge ;
- modification de ses dimensions géométriques ;
- utilisation d'un support de jauge de module d'Young différent ;
- utilisation d'un matériau ayant une résistivité plus importante.

Des paramètres de variations similaires sont envisageables pour d'autres technologies d'éléments sensibles 2, par exemple :

- la nature des matériaux utilisés ou leurs caractéristiques physiques (dopage, structure atomique, ...) ;
- le nombre de couche pour une technologie magnétorésistive ;
- la géométrie ou la forme de l'élément sensible 2 ;
- le courant ou la tension de polarisation de l'élément sensible 2.

Naturellement, le nombre d'éléments sensibles 2 et les caractéristiques de ceux-ci peuvent être combinés de sorte à obtenir le gain souhaité pour les signaux de sortie respectifs.

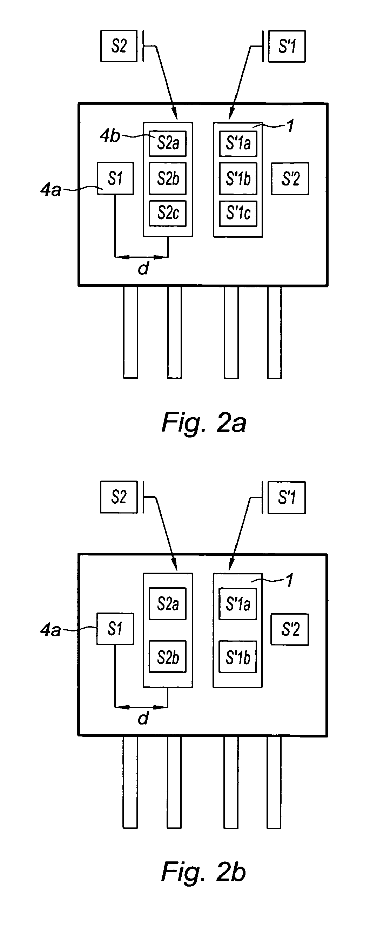

Les figures 2 représentent un mode de réalisation d'un capteur comprenant quatre zones sensibles 1 formées de sous-zones 4, lesdites sous-zones étant disposées de sorte que les barycentres des zones 1 soient linéairement équirépartis d'une distance d. L'agencement respectif des zones 1 est prévu pour pouvoir combiner les signaux issus des sous-zones 4 de façon particulière afin de pouvoir former des signaux U et W de même amplitude. En particulier, les arrangements représentés permettent d'obtenir un gain de 2 sur les points de mesure virtuels internes.

Selon la première variante de la figure 2a, le capteur comprend quatre sous-zones 4 sensibles identiques qui sont linéairement équiréparties d'une distance d. Les quatre sous-zones 4a délivrent respectivement les signaux $S_1$, $S_{2b}$, $S'_{1b}$ et $S'_2$ d'amplitude identique.

Chaque zone latérale est formée d'une sous-zone 4a. Pour chaque zone interne, deux sous-zones supplémentaires 4b, respectivement supérieure et inférieure, sont prévues avec une distance identique entre les sous-zones supplémentaires 4b et la sous-zone centrale 4a, et les zones internes sont identiques. Ces sous-zones supplémentaire 4b délivrent respectivement les signaux $S_{2a}$, $S_{2c}$, $S'_{1a}$, $S'_{1c}$ d'amplitude identique.

Les sous-zones supplémentaires 4b sont agencées pour délivrer chacune un signal présentant une amplitude deux fois plus petite que celle de la sous-zone centrale 4a.

Ainsi, en supposant que l'amplitude du signal pseudo sinusoïdal du codeur varie pas ou peu selon l'axe perpendiculaire à la direction d'alignement, on peut former les signaux :

$$U = (S_1 - S_{2b}) - (S'_{1b} - S'_2)$$

$$W = (S_{2a} + S_{2b} + S_{2c}) - (S'_{1a} + S'_{1b} + S'_{1c})$$

Et, dans le cas ou la distance d entre les points virtuels de mesure est égale au quart de la période spatiale du signal sinusoïdal à mesurer, les signaux U et W ont la même amplitude, et ce uniquement par construction et sans amplification des signaux issus des zones sensibles.

Selon la deuxième variante de la figure 2b, le capteur comprend six sous-zones sensibles 4a identiques, les deux zones internes comprenant chacune deux sous-zones réparties de part et d'autre de la direction d'alignement des zones latérales. Ainsi, les deux zones latérales comprennent chacune une sous-zone et les deux zones internes comprennent chacune deux sous-zones.

Les signaux suivants peuvent alors être formés :

$$U = (S_1 - S_{2a}) - (S'_{1a} - S'_2) \; ; \; ou$$

$$U = (S_1 - S_{2a}) - (S'_{1b} - S'_2); \text{ ou}$$

$$U = (S_1 - S_{2b}) - (S'_{1a} - S'_2) ; \text{ ou}$$

$$U = (S_1 - S_{2b}) - (S'_{1b} - S'_2) ; \text{ et}$$

$$W = (S_{2a} + S_{2b}) - (S'_{1a} + S'_{1b}).$$

Et, dans le cas ou la distance d entre les points virtuels de mesure est égale au quart de la période spatiale du signal sinusoïdal à mesurer, les signaux U et W ont la même amplitude, et ce uniquement par construction et sans amplification des signaux issus des zones sensibles.

L'invention concerne également deux intégrations particulières d'un capteur dans un palier comprenant un organe fixe et un organe tournant.

Selon une première réalisation, un codeur délivrant un signal pseudo sinusoïdal de position est solidarisé à l'organe tournant et le capteur est solidarisé à l'organe fixe de sorte que les zones sensibles 1 soient disposées à distance de lecture du signal émis par le codeur.

Selon une deuxième réalisation, des corps roulants sont disposés entre les organes pour permettre leur rotation relative en induisant un signal pseudo sinusoïdal de déformation. Les zones sensibles 1 sont solidarisées à un organe de sorte à détecter le signal pseudo sinusoïdal.

**Revendications**

1. Capteur d'un signal pseudo sinusoïdal, ledit capteur comprenant une pluralité de zones sensibles (1) qui sont aptes à délivrer chacune un signal $S_i$ représentatif du signal à détecter, ledit capteur étant **caractérisé en ce que** les zones sensibles (1) sont agencées de sorte que, pour un même signal détecté, au moins une zone sensible (1) délivre un signal $S_i$ d'amplitude différente de celle du signal délivré par une autre zone sensible (1).

2. Capteur selon la revendication 1, **caractérisé en ce que** les zones sensibles (1) sont linéairement équiréparties.

3. Capteur selon la revendication 1 ou 2, **caractérisé en ce qu'**il comprend en outre des moyens de combinaison linéaire des signaux $S_i$, lesdits moyens étant agencés pour former au moins un signal pseudo sinusoïdal.

4. Capteur selon l'une quelconque des revendications 1 à 3, **caractérisé en ce qu'**au moins une zone sensible (1) comprend une pluralité d'éléments sensibles (2) dont le nombre est ajusté pour délivrer un signal $S_i$ d'amplitude déterminée, ledit capteur comprenant en outre des moyens de sommation des signaux issus de chaque élément sensible (2) d'une zone (1) de sorte à former le signal $S_i$ de ladite zone.

5. Capteur selon l'une quelconque des revendications 1 à 4, **caractérisé en ce qu'**au moins une zone sensible (1) comprend au moins un élément sensible (2) qui est agencé pour délivrer un signal $S_i$ d'amplitude déterminée.

6. Capteur selon la revendication 5, **caractérisé en ce que** le paramètre de l'élément sensible (2) qui permet d'obtenir l'amplitude déterminée est choisi dans le groupe comprenant la géométrie de l'élément sensible (2), sa polarisation, le matériau le composant, une combinaison de ces paramètres.

7. Capteur selon l'une quelconque des revendications 1 à 6, **caractérisé en ce que** les zones sensibles (1) sont formées de sous-zones sensibles (4), ledit capteur comprenant des moyens de combinaison linéaire des signaux issus des sous-zones (4) de sorte à former au moins un signal pseudo sinusoïdal.

8. Palier équipé d'un capteur selon l'une quelconque des revendications 1 à 7, ledit palier comprenant un organe fixe et un organe tournant, dans lequel un codeur délivrant un signal pseudo sinusoïdal de position est solidarisé à l'organe tournant et le capteur est solidarisé à l'organe fixe de sorte que les zones sensibles (1) soient disposées à distance de lecture du signal émis par le codeur.

9. Palier à roulement équipé d'un capteur selon l'une quelconque des revendications 1 à 7, ledit palier comprenant un organe fixe et un organe tournant entre lesquels des corps roulants sont disposés pour permettre leur rotation relative en induisant un signal pseudo sinusoïdal de déformation, dans lequel les zones sensibles (1) sont solidarisées à un organe de sorte à détecter ledit signal pseudo sinusoïdal.

*Fig. 1a*

*Fig. 1b*

*Fig. 1c*

S2

S'1

4b — S2a

S'1a

1

S1

S2b

S'1b

S'2

4a —

S2c

S'1c

d

## Fig. 2a

S2

S'1

S2a

S'1a

1

4a —

S1

S'2

S2b

S'1b

d

## Fig. 2b

**Office européen
des brevets**

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X<br><br>Y | FR 2 861 459 A1 (SKF AB [SE]) 29 avril 2005 (2005-04-29) * page 6, ligne 17 - page 10, ligne 17; figures 1,2 * ----- | 1-3,5,6, 8,9<br>7 | INV. G01D5/14 G01D5/244 |
| D,Y | FR 2 792 403 A1 (ROULEMENTS SOC NOUVELLE [FR]) 20 octobre 2000 (2000-10-20) * figure 2 * ----- | 7 | |
| X | DE 100 58 623 A1 (DAIMLER CHRYSLER AG [DE]) 13 juin 2002 (2002-06-13) * abrégé; figures 1-3 * * alinéa [0018] - alinéa [0025] * ----- | 1,2,5,6, 8,9 | |
| A | DE 103 20 057 A1 (SCHOEDLBAUER DIETER [DE]) 2 décembre 2004 (2004-12-02) * le document en entier * ----- | 1 | |

**DOMAINES TECHNIQUES RECHERCHES (IPC)**

G01D

Le présent rapport a été établi pour toutes les revendications

| Lieu de la recherche | Date d'achèvement de la recherche | Examinateur |
|---|---|---|
| La Haye | 6 novembre 2007 | Amroun, Sébastien |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

    ..........................................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 07 29 0860

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-11-2007

| Document brevet cité au rapport de recherche | | Date de publication | Membre(s) de la famille de brevet(s) | | Date de publication |
|---|---|---|---|---|---|
| FR 2861459 | A1 | 29-04-2005 | EP<br>WO<br>JP | 1676100 A2<br>2005043088 A2<br>2007509336 T | 05-07-2006<br>12-05-2005<br>12-04-2007 |
| FR 2792403 | A1 | 20-10-2000 | BR<br>EP<br>WO<br>JP<br>US | 0006037 A<br>1088202 A1<br>0062020 A1<br>2002541470 T<br>6573710 B1 | 13-03-2001<br>04-04-2001<br>19-10-2000<br>03-12-2002<br>03-06-2003 |
| DE 10058623 | A1 | 13-06-2002 | AUCUN | | |
| DE 10320057 | A1 | 02-12-2004 | AUCUN | | |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2792403 A1

- FR 2869980 A1